# EUROPÄISCHE PATENTSCHRIFT

(11) **EP 2 193 550 B1**
(45) Veröffentlichungstag und Bekanntmachung des Hinweises auf die Patenterteilung: **08.03.2017**
(21) Anmeldenummer: 08801254.7
(22) Anmeldetag: 28.08.2008
(51) Int. Cl.: H01L 33/00

(54) **STRAHLUNGSEMITTIERENDER HALBLEITERKÖRPER**
RADIATION-EMITTING SEMICONDUCTOR BODY
CORPS SEMI-CONDUCTEUR ÉMETTANT UN RAYONNEMENT

(30) Priorität: 28.09.2007 DE 102007046499
(43) Veröffentlichungstag der Anmeldung: 09.06.2010
(73) Patentinhaber: OSRAM Opto Semiconductors GmbH, 93055 Regensburg (DE)
(72) Erfinder: ALBRECHT, Tony, 93077 Bad Abbach (DE); BADER, Stefan, 93080 Pentling - Matting (DE); HAHN, Berthold, 93155 Hemau (DE)
(74) Vertreter: Epping - Hermann - Fischer
(86) Internationale Anmeldenummer: PCT/DE2008/001447
(87) Internationale Veröffentlichungsnummer: WO 2009/039815

(56) Entgegenhaltungen:
- EP-A- 1 132 977
- WO-A-02/097902
- DE-A1-102004 052 245
- US-A1- 2002 139 984
- US-A1- 2003 006 430
- US-A1- 2006 145 137

## Beschreibung

Es wird ein strahlungsemittierender Halbleiterkörper beschrieben.

Bei herkömmlichen Leuchtdioden besteht eine Möglichkeit zur Erzeugung von mischfarbiger Strahlung darin, dass von einem Halbleiterkörper Strahlung einer ersten Wellenlänge erzeugt wird, die nachfolgend mittels eines Leuchtstoffs in Strahlung einer zweiten Wellenlänge umgewandelt wird. Somit emittiert der Halbleiterkörper in Verbindung mit dem Leuchtstoff mischfarbige Strahlung der ersten und der zweiten Wellenlänge.

Die Herstellung einer solchen Leuchtdiode erfordert allerdings eine genaue Abstimmung des Leuchtstoffs auf die jeweilige Emissionswellenlänge des Halbleiterkörpers sowie ein präzises Dosierungs- und Applikationsverfahren für den Leuchtstoff.

In EP 1 132 977 wird ein Licht emittierendes Bauelement beschrieben, bei dem eine aktive Schicht zur Emission von Primärstrahlung vorgesehen ist und eine weitere Licht emittierende Schicht von der Primärstrahlung angeregt wird.

Eine Aufgabe besteht darin, einen Halbleiterkörper anzugeben, der vereinfacht herstellbar ist. Insbesondere soll der Halbleiterkörper im Betrieb eine hohe Effizienz aufweisen. Weiterhin soll ein effizientes Verfahren zur Erzeugung mischfarbiger Strahlung oder zur Umwandlung von Strahlung mittels eines Halbleiterkörpers angegeben werden.

Diese Aufgabe wird durch einen Halbleiterkörper mit den Merkmalen des Patentanspruchs 1 beziehungsweise ein Verfahren nach Anspruch 14 gelöst. Bevorzugte Ausgestaltungen und Weiterbildungen sind Gegenstand der abhängigen Ansprüche.

In dem strahlungsemittierenden Halbleiterkörper ist eine aktive Schicht zur Erzeugung von Strahlung einer ersten Wellenlänge und eine Reemissionsschicht, die eine Quantentopfstruktur mit einer Quantenschichtstruktur und einer Barriereschichtstruktur aufweist, ausgebildet, wobei die aktive Schicht und die Reemissionsschicht monolithisch in den Halbleiterkörper integriert sind und die Reemissionsschicht zur Erzeugung von inkohärenter Strahlung einer zweiten Wellenlänge mittels Absorption der Strahlung der ersten Wellenlänge in der

Barriereschichtstruktur vorgesehen ist. Bevorzugt ist auch die von der aktiven Schicht erzeugte Strahlung der ersten Wellenlänge inkohärent.

Die Bezeichnung Quantentopfstruktur umfasst im vorliegenden Zusammenhang insbesondere jegliche Struktur, bei der Ladungsträger durch Einschluss ("confinement") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Unter einer "aktiven Schicht" ist vorliegend im Zweifel eine elektrisch anregbare strahlungserzeugende Schicht zu verstehen. Die Reemissionsschicht wird im Gegensatz dazu optisch gepumpt.

Bei dem Halbleiterkörper sind die aktive Schicht zur Erzeugung von Strahlung einer ersten Wellenlänge und die Reemissionsschicht zur zumindest teilweisen Umwandlung der Strahlung der ersten Wellenlänge in Strahlung der zweiten Wellenlänge monolithisch integriert. Die Dosierung und Aufbringung eines Leuchtstoffs zur Konversion der Strahlung der ersten Wellenlänge in Strahlung der zweiten Wellenlänge kann somit vorteilhafterweise entfallen.

Weiterhin werden auch durch einen Leuchtstoff induzierte Strahlungsverluste, beispielsweise Streuverluste, vermieden. Damit wird die Effizienz des strahlungsemittierenden Halbleiterkörpers vorteilhaft erhöht.

Ferner können auch charakteristische optische Parameter des Halbleiterkörpers wie beispielsweise Farbort und/oder Farbtemperatur der erzeugten Strahlung bereits bei der Herstellung des Halbleiterkörpers eingestellt werden. Hierdurch sind Kostenvorteile bei der Herstellung, insbesondere bei der Herstellung des Halbleiterkörpers in einem Wafer-Prozess, erzielbar.

Schließlich wird bei dem Halbleiterkörper ein farbiges Erscheinungsbild im ausgeschalteten Zustand, wie es beispielsweise bei herkömmlichen Leuchtdioden durch den Leuchtstoff hervorgerufen sein kann, vermieden. Ein solches farbiges Erscheinungsbild ist oftmals unerwünscht. Gesonderte Herstellungsschritte zur Vermeidung eines solchen farbigen Erscheinungsbildes, die zudem zu einer geringeren Effizienz beziehungsweise einer Abdunklung des Halbleiterkörpers führen können, sind nicht erforderlich.

Bei einer bevorzugten Weiterbildung des Halbleiterkörpers weist die Barriereschichtstruktur eine oder eine Mehrzahl von Barriereschichten auf. Entsprechend kann auch die Quantenschichtstruktur eine oder eine Mehrzahl von Quantenschichten aufweisen.

Weiter bevorzugt sind die Barriereschichten und die Quantenschichten alternierend angeordnet. Eine alternierende Anordnung bedeutet mit anderen Worten, dass in der Abfolge von Barriere- und Quantenschichten jeweils eine Barriereschicht auf eine Quantenschicht folgt und umgekehrt.

Die Quantentopfstruktur kann somit als Einfachquantentopfstruktur (SQW, Single Quantum Well) oder Mehrfachquantentopfstruktur (MQW, Multiple Quantum Well) ausgebildet sein, wobei der Quantentopf beziehungsweise die Quantentöpfe jeweils durch eine Quantenschicht zwischen zwei angrenzenden Barriereschichten gebildet ist.

Bei einer weiteren Ausgestaltung des Halbleiterkörpers wird die Strahlung der zweiten Wellenlänge in der Quantenschichtstruktur, also etwa in der Quantenschicht beziehungsweise den Quantenschichten erzeugt. Die räumliche Trennung von Absorption der Strahlung der ersten Wellenlänge und Erzeugung der Strahlung der zweiten Wellenlänge hat den Vorteil einer größeren Effizienz der Reemissionsschicht und damit des strahlungsemittierenden Halbleiterkörpers. Insbesondere sind in der Regel die Barriereschichten wesentlich dicker als die Quantenschichten ausgeführt, so dass die Absorption der Strahlung der ersten Wellenlänge in den Barriereschichten wesentlich größer und damit insgesamt die Anregung der Reemissionsschicht wesentlich effizienter ist als bei Absorption der Strahlung der ersten Wellenlänge in der Quantenschichtstruktur beziehungsweise den entsprechenden Quantenschichten.

Bei einer weiteren vorteilhaften Ausgestaltung enthält der Halbleiterkörper ein Verbindungshalbleitermaterial, insbesondere ein Nitrid-Verbindungshalbleitermaterial oder ein Phosphid-Verbindungshalbleitermaterial.

Insbesondere kann der strahlungsemittierende Halbleiterkörper auf einem Verbindungshalbleitermaterial, weiter bevorzugt auf einem Nitrid-Verbindungshalbleitermaterial oder einem Phosphid-Verbindungshalbleitermaterial, basieren. Diese Halbleitermaterialien zeichnen sich durch eine besonders effiziente Strahlungserzeugung aus, wobei vorteilhafterweise durch die monolithische Integration der Reemissionsschicht ein Emissionsspektrum erzielbar ist, das mit einer aktiven Schicht auf der Basis eines Nitrid- beziehungsweise Phosphid-Verbindungshalbleiters allein üblicherweise nicht erzeugbar ist.

Insbesondere können optische Parameter des Halbleiterkörpers wie beispielsweise Farbort und/oder Farbtemperatur in weiten Grenzen durch entsprechende Gestaltung der Reemissionsschicht frei eingestellt werden.

"Auf Nitrid-Verbindungshalbleitern basierend" bedeutet im vorliegenden Zusammenhang, dass der Halbleiterkörper, bevorzugt die aktive Schicht und/oder die Reemissionsschicht oder zumindest eine Teilschicht davon, ein Nitrid-III/V-Verbindungshalbleitermaterial, vorzugsweise AlₙGaₘIn₁₋ₙ₋ₘN, enthält, wobei 0 ≤ n ≤ 1, 0 ≤ m ≤ 1 und n+m ≤ 1 ist, vorzugsweise mit n ≠ 0 und/oder m ≠ 0. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Phosphid-Verbindungshalbleitern basierend" bedeutet in diesem Zusammenhang, dass der Halbleiterkörper, bevorzugt die aktive Schicht und/oder die Reemissionsschicht oder zumindest eine Teilschicht davon, ein Phosphid-III/V-Verbindungshalbleitermaterial, vorzugsweise AlₙGaₘIn₁₋ₙ₋ₘP, enthält, wobei 0 ≤ n ≤ 1, 0 ≤ m ≤ 1 und n+m ≤ 1 ist, vorzugsweise mit n ≠ 0 und/oder m ≠ 0. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Bei einer bevorzugten Ausgestaltung des Halbleiterkörpers wird die Strahlung der ersten Wellenlänge nur teilweise in Strahlung der zweiten Wellenlänge mittels der Reemissionsschicht umgewandelt, so dass der Halbleiterkörper der gleichzeitigen Emission von Strahlung der ersten Wellenlänge und Strahlung der zweiten Wellenlänge dient.

Weiter bevorzugt kann die erste Wellenlänge im blauen Spektralbereich, etwa mit einer Wellenlänge zwischen einschließlich 440 nm und einschließlich 470 nm, und die zweite Wellenlänge im gelb-orangen Spektralbereich liegen, so dass mischfarbige Strahlung mit einem weißen Gesamtfarbeindruck emittiert wird. Der Halbleiterkörper stellt in dieser Ausgestaltung eine monolithisch integrierte Weißlichtquelle dar.

Alternativ kann auch vorgesehen sein, dass die Strahlung der ersten Wellenlänge im Wesentlichen vollständig mittels der Reemissionsschicht in Strahlung der zweiten Wellenlänge umgewandelt wird, so dass der strahlungsemittierende Halbleiterkörper also im Betrieb nur Strahlung der zweiten Wellenlänge emittiert. Beispielsweise kann vorgesehen sein, dass die aktive Schicht ultraviolette Strahlung erzeugt, die vollständig in Strahlung mit einer zweiten Wellenlänge im sichtbaren Spektralbereich, zum Beispiel im grünen Spektralbereich, umgewandelt wird. Bei einer vorteilhaften Weiterbildung dieser Alternative ist der Halbleiterkörper abstrahlungsseitig mit einer Reflexionsschicht versehen, die die Strahlung der ersten Wellenlänge selektiv in den Halbleiterkörper zurückreflektiert. Die zurückreflektierten Strahlungsanteile werden so erneut der Reemissionsschicht zur Umwandlung zugeführt.

Je nach Anforderung kann also mit dem strahlungsemittierenden Halbleiterkörper mischfarbige Strahlung oder aber Strahlung einer Wellenlänge, die nicht der Emissionswellenlänge der aktiven Schicht des Halbleiterkörpers entspricht, erzeugt werden.

Im Falle eines Halbleiterkörpers auf der Basis eines Nitrid-Verbindungshalbleitermaterials enthält die aktive Schicht vorzugsweise InGaN.

Weiter bevorzugt liegt die erste Wellenlänge zwischen 360 nm und 400 nm, wobei die Bereichsgrenzen eingeschlossen sind.

In einer bevorzugten Weiterbildung enthält die Barriereschichtstruktur GaN.

Insbesondere eine InGaN enthaltende aktive Schicht eignet sich in Verbindung mit einer Barriereschichtstruktur auf der Basis von GaN, welche mit der genannten Wellenlänge in einem Bereich zwischen 360 nm und 400 nm besonders effizient anregbar ist.

Ein Halbleiterkörper auf der Basis eines Nitrid-Verbindungshalbleitermaterials eignet sich auch für die Erzeugung von Strahlung im blauen Spektralbereich, etwa mit einer Wellenlänge zwischen einschließlich 440 nm und einschließlich 470 nm.

Vorzugsweise ist der strahlungsemittierende Halbleiterkörper als Dünnfilm-Halbleiterkörper ausgeführt.

Ein Dünnfilm-Halbleiterkörper zeichnet sich insbesondere durch mindestens eines der nachfolgenden charakteristischen Merkmale aus:
- an einer zu einem Träger hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und/oder
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert scher Oberflächenstrahler.

Alternativ kann der Halbleiterkörper auch mit einem Substrat in Form des Aufwachssubstrats (auch Epitaxiesubstrat genannt) versehen sein, das vorzugsweise für die erzeugte Strahlung der ersten und/oder der zweiten Wellenlänge durchlässig ist.

Bei einer vorteilhaften Weiterbildung ist der Halbleiterkörper gegenüber der Abstrahlungsseite mit einer Spiegelschicht versehen. Dadurch wird der Anteil der abstrahlungsseitig ausgekoppelten Strahlung vorteilhaft erhöht. Weiterhin können zur Spiegelschicht hin- und rücklaufende Anteile der Strahlung der ersten Wellenlänge ein Stehwellenfeld bilden. Bevorzugt ist in diesem Fall die Reemissionsschicht in einem Maximum des Stehwellenfeldes, also einem Wellenbauch, angeordnet. Hierdurch wird eine vorteilhaft hohe Absorption der Strahlung der ersten Wellenlänge erzielt und damit die Effizienz der Erzeugung der Strahlung der zweiten Wellenlänge erhöht.

Bei dem Verfahren zur Erzeugung mischfarbiger Strahlung oder zur Umwandlung von Strahlung mittels eines Halbleiterkörpers enthält der Halbleiterkörper eine aktive Schicht und eine Reemissionsschicht. Die Reemissionsschicht weist eine Quantentopfstruktur mit einer Quantenschichtstruktur und einer Barriereschichtstruktur auf. Die Erzeugung mischfarbiger Strahlung beziehungsweise die Umwandlung von Strahlung erfolgt mit den Schritten:
- Erzeugen von vorzugsweise inkohärenter Strahlung einer ersten Wellenlänge (λ₁) in der aktiven Schicht;
- zumindest teilweises Absorbieren der Strahlung einer ersten Wellenlänge (λ₁) in der Barriereschichtstruktur, und
- Erzeugen von inkohärenter Strahlung einer zweiten Wellenlänge (λ₂) in der Quantenschichtstruktur.

Wird in der Barriereschichtstruktur nur ein Teil der Strahlung der ersten Wellenlänge absorbiert, so kann der verbleibende Teil der Strahlung der ersten Wellenlänge zusammen mit der in der Quantenschichtstruktur generierten Strahlung der zweiten Wellenlänge abgestrahlt werden, so dass insgesamt mischfarbige Strahlung erzeugt wird, die insbesondere Spektralanteile der ersten und der zweiten Wellenlänge enthält.

Alternativ kann die Strahlung der ersten Wellenlänge vollständig in der Barriereschichtstruktur absorbiert werden, so dass eine vollständige Umwandlung der Strahlung der ersten Wellenlänge in Strahlung der zweiten Wellenlänge erfolgt.

"Vollständig" bedeutet in diesem Zusammenhang, dass abgesehen von vernachlässigbaren oder unvermeidlichen Restanteilen der Strahlung der ersten Wellenlänge der Halbleiterkörper in Hauptabstrahlrichtung nur Strahlung der zweiten Wellenlänge emittiert. Ein möglichst vollständiger Energieübertrag der Strahlung der ersten Wellenlänge in Strahlung der zweiten Wellenlänge ist zwar anzustreben, aber nicht unbedingt erforderlich.

Bevorzugt wird das Verfahren mittels eines Halbleiterkörpers mit mindestens einem der oben beschriebenen Merkmale durchgeführt.

Weitere Merkmale, Vorzüge und Zweckmäßigkeiten der Erfindung ergeben sich aus den nachfolgend beschriebenen Ausführungsbeispielen in Verbindung mit den Figuren 1 bis 5.

Es zeigen:
- Figur 1: eine schematische Schnittdarstellung eines ersten Ausführungsbeispiels des Halbleiterkörpers,
- Figur 2: eine schematische Darstellung eines Ausführungsbeispiels des Verfahrens zur Erzeugung mischfarbiger Strahlung beziehungsweise zur Umwandlung von Strahlung,
- Figur 3: eine schematische Schnittdarstellung eines zweiten Ausführungsbeispiels des Halbleiterkörpers,
- Figur 4: eine schematische Schnittdarstellung eines dritten Ausführungsbeispiels des Halbleiterkörpers, und
- Figur 5: eine schematische Schnittdarstellung eines vierten Ausführungsbeispiels des Halbleiterkörpers.

Gleiche oder gleichwirkende Elemente sind in den Figuren mit denselben Bezugszeichen versehen.

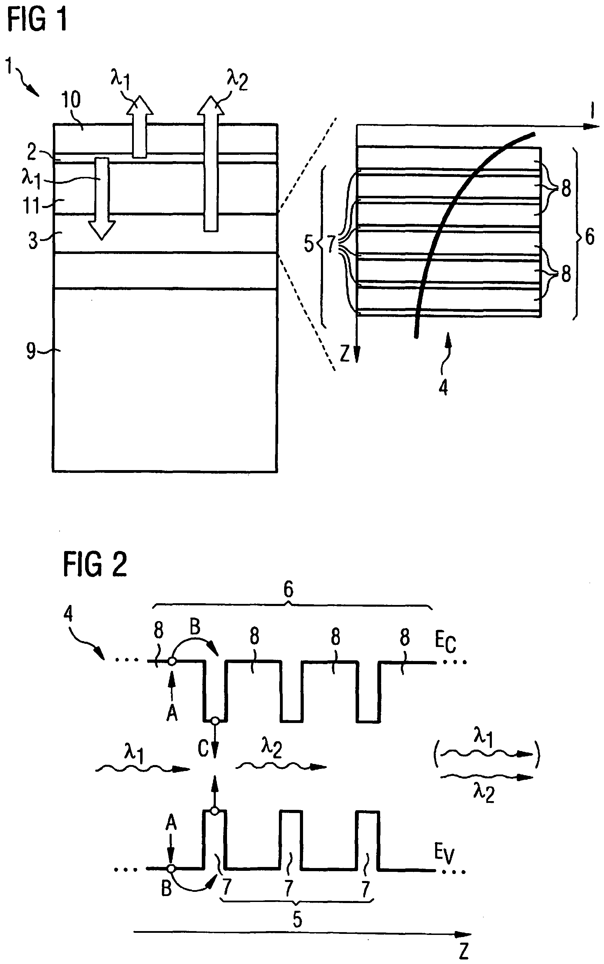

In Figur 1 ist ein strahlungsemittierender Halbleiterkörper 1 dargestellt, der eine strahlungserzeugende aktive Schicht 2 sowie eine Reemissionsschicht 3 aufweist.

Auf der der Hauptabstrahlungsseite abgewandten Seite des Halbleiterkörpers ist ein Substrat 9, beispielsweise ein Aufwachssubstrat, auf das die Reemissionsschicht 3 und die aktive Schicht 2 epitaktisch aufgewachsen sind, angeordnet.

Alternativ kann der Halbleiterkörper auch als Dünnfilm-Halbleiterkörper ausgeführt sein, wobei in diesem Fall das Aufwachssubstrat abgedünnt oder vorzugsweise vollständig entfernt ist und der Halbleiterkörper auf einen externen Träger aufgebracht ist.

Im Betrieb wird mittels der aktiven Schicht 2 Strahlung einer ersten Wellenlänge λ₁ erzeugt. Ein Teil dieser Strahlung der ersten Wellenlänge λ₁ wird in der unterhalb der aktiven Schicht 2 angeordneten Reemissionsschicht 3 absorbiert, was zur Emission von Strahlung einer zweiten Wellenlänge λ₂ führt. Mittels der Reemissionsschicht 3 wird also Strahlung der Wellenlänge λ₁ zumindest teilweise in Strahlung der Wellenlänge λ₂ umgewandelt.

Wie die Ausschnittvergrößerung der Reemissionsschicht 3 in Figur 1 zeigt, weist die Reemissionsschicht 3 eine Quantentopfstruktur 4 mit einer Quantenschichtstruktur 5 und einer Barriereschichtstruktur 6 auf. Die Quantenschichtstruktur 5 umfasst eine Mehrzahl von Quantenschichten 7. Entsprechend umfasst die Barriereschichtstruktur 6 eine Mehrzahl von Barriereschichten 8. Die Quantentopfstruktur ist in diesem Fall also in Form einer Mehrfachquantentopfstruktur (MQW) ausgebildet, wobei die Quantenschichten 7 und die Barriereschichten 8 alternierend angeordnet sind.

Durch entsprechende Dimensionierung der Quantentopfstruktur kann die Wellenlänge λ₂ der von der Reemissionsschicht erzeugten Strahlung und weitergehend der Farbort und/oder die Farbtemperatur der insgesamt von dem Halbleiterkörper emittierten Strahlung in weiten Grenzen frei eingestellt werden.

Zudem ist es möglich, die Zusammensetzung und/oder die Dicke der Barriere- und/oder der Quantenschichten in der Reemissionsschicht in vertikaler Richtung zu variieren, so dass die spektrale Breite der von der Reemissionsschicht erzeugten Strahlung erhöht wird. Dies ist beispielsweise vorteilhaft bei der Erzeugung weißen Lichts, wenn ein Gesamteindruck ähnlich einer Glühlampe mit einem breiten Weißlichspektrum gewünscht ist.

In der Ausschnittvergrößerung der Reemissionsschicht 3 in Figur 1 ist weiterhin die Intensität I der Strahlung der Wellenlänge λ₁ in vertikaler Richtung z, also entlang der Auswachsrichtung der Quantentopfstruktur 4 schematisch aufgetragen. Aufgrund der Absorption der Strahlung der Wellenlänge λ₁ in den Barriereschichten 8 der Barriereschichtstruktur 6 nimmt die Intensität I der Strahlung der Wellenlänge λ₁ kontinuierlich mit wachsendem Abstand z von der aktiven Schicht 2 ab.

Der Halbleiterkörper 1 kann beispielsweise auf der Basis eines Nitrid-Verbindungshalbleiters ausgebildet sein. In diesem Fall kann beispielsweise die aktive Schicht 2 zwischen einer oberseitigen p-GaN-Schicht 10 und einer n-GaN-Schicht 11 angeordnet sein. Die aktive Schicht 2 kann auf InGaN basieren und ebenfalls als Einfach- oder Mehrfachquantentopfstruktur ausgeführt sein.

Vorzugsweise ist die Wellenlänge λ₁ der von der aktiven Schicht erzeugten Strahlung so gewählt, dass eine ausreichend hohe Absorption in den Barriereschichten 8 der Reemissionsschicht 3 erzielt wird. Barriereschichten auf der Basis von GaN in Verbindung einer aktiven Schicht auf der Basis von InGaN sind hierfür besonders geeignet.

In Figur 2 ist schematisch dargestellt, wie mittels des Halbleiterkörpers Strahlung der ersten Wellenlänge λ₁ teilweise oder vollständig in Strahlung der zweiten Wellenlänge λ₂ umgewandelt wird.

Aufgetragen ist ausschnittsweise das Energieniveau E_{C} des Valenzbandes und das Energieniveau E_{V} des Leitungsbandes der Reemissionsschicht.

Im Betrieb wird die von der aktiven Schicht erzeugte Strahlung der ersten Wellenlänge λ₁ in der Barriereschichtstruktur 6, also in den Barriereschichten 8, der Reemissionsschicht absorbiert, wodurch zunächst in den Barriereschichten 8 eine Ladungsträgertrennung erfolgt (Schritt A). Die so getrennten Ladungsträger werden in den energetisch tiefer liegenden Quantentöpfen der Quantentopfstruktur 4, also in den Quantenschichten 7 der Quantenschichtstruktur 5 eingefangen (Schritt B) und führen dort durch Rekombination zur Emission der Strahlung mit der Wellenlänge λ₂ (Schritt C).

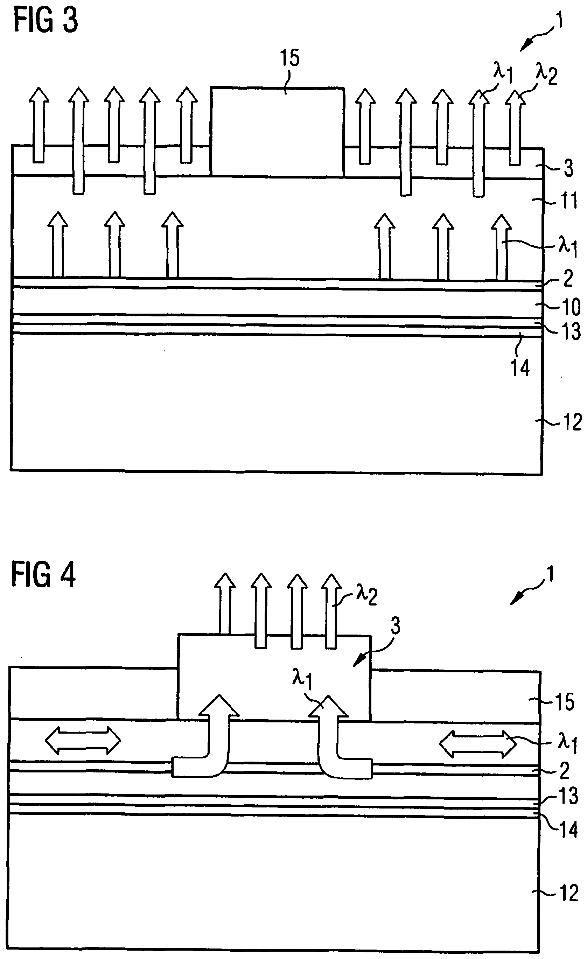

In Figur 3 ist ein weiteres Ausführungsbeispiel des Halbleiterkörpers dargestellt. Im Unterschied zu dem in Figur 1 gezeigten Halbleiterkörper ist dieser Halbleiterkörper als Dünnfilm-Halbleiterkörper gebildet.

Wie im vorherigen Ausführungsbeispiel weist der Halbleiterkörper eine aktive Schicht 2 und eine Reemissionsschicht 3 auf. Die Reemissionsschicht 3 kann wie in dem vorherigen Ausführungsbeispiel als Mehrfachquantentopfstruktur mit einer Mehrzahl von alternierend angeordneten Barriere- und Quantenschichten ausgeführt sein.

Die Reemissionsschicht 3 ist abstrahlungsseitig auf eine n-GaN-Schicht 11 aufgebracht. Die n-GaN-Schicht dient unter anderem der Stromaufweitung in dem Halbleiterkörper. Die aktive Schicht 2 ist zwischen der n-GaN-Schicht 11 und einer p-GaN-Schicht 10 angeordnet. Hinsichtlich des Leitungstyps ist der in Figur 3 dargestellte Halbleiterkörper invers zu dem in Figur 1 dargestellten Halbleiterkörper.

Allgemein kann im vorliegenden Zusammenhang die Reemissionsschicht p-leitend, n-leitend, undotiert oder auch kodotiert sein. Unabhängig davon kann die Reemissionsschicht zwischen einem Substrat beziehungsweise Träger und der aktiven Schicht oder auf einer dem Substrat beziehungsweise Träger abgewandten Seite der aktiven Schicht angeordnet sein.

Im Unterschied zum vorherigen Ausführungsbeispiel ist der in Figur 3 dargestellt Halbleiterkörper 1 auf einem Träger 12 aufgebracht, wobei das Epitaxiesubstrat (nicht dargestellt) vom Halbleiterkörper abgelöst wurde. Auf der dem Träger 12 zugewandten Seite des Halbleiterkörpers 1 ist eine Kontaktschicht 13 und nachfolgend eine Lotschicht 14 zur Verbindung des Halbleiterkörpers mit dem Träger 10 ausgebildet.

Weiterhin kann zwischen dem Halbleiterkörper und dem Träger eine Spiegelschicht (nicht dargestellt) angeordnet sein, die der Reflektion von Strahlung, die in Richtung des Trägers 12 emittiert wird, dient, so dass auch derartige Strahlungsteile auf der oberseitigen Abstrahlungsseite des Halbleiterkörpers emittiert werden. Vorteilhaft ist eine Ausgestaltung der Spiegelschicht in Form eines auf den Halbleiter aufgebrachten Dielektrikums oder einer auf den Halbleiter aufgebrachten TCO-Schicht (Transparent Conductive Oxide), dem beziehungsweise der eine Metallschicht auf der von dem Halbleiterkörper abgewandten Seite nachgeordnet ist. Auf diese Art und Weise ist ein hoher Reflexionsgrad der Spiegelschicht erzielbar.

Zur Spiegelschicht hin- und rücklaufende Anteile der Strahlung der ersten Wellenlänge können ein Stehwellenfeld bilden. Bevorzugt ist in diesem Fall die Reemissionsschicht 3 in einem Wellenbauch angeordnet. Hierdurch wird eine vorteilhaft hohe Absorption der Strahlung der ersten Wellenlänge λ₁ erzielt und damit die Effizienz der Erzeugung der Strahlung der zweiten Wellenlänge λ₂ erhöht.

Auf der dem Träger 10 abgewandten Seite ist zur elektrischen Versorgung des Halbleiterkörpers ein Kontakt 15 in Form eines Bondpads ausgebildet.

Wie bereits ausgeführt wird in der aktiven Schicht 2 Strahlung der ersten Wellenlänge λ₁ erzeugt. Eine Teil dieser Strahlung wird innerhalb der Reemissionsschicht 3 in der Barriereschichtstruktur absorbiert und führt zur Emission von Strahlung der zweiten Wellenlänge λ₂. Diese Strahlung der zweiten Wellenlänge λ₂ wird zusammen mit dem verbleibenden Anteil der Strahlung der ersten Wellenlänge λ₁ emittiert, so dass der Halbleiterkörper mischfarbige Strahlung emittiert. Werden die aktive Schicht und die Reemissionsschicht derart ausgeführt, dass die erste Wellenlänge λ₁ im blauen Spektralbereich und die zweite Wellenlänge λ₁ im gelb-orangen Spektralbereich liegt, so kann sich ein weißer Farbeindruck ergeben. In dieser vorteilhaften Ausgestaltung stellt der Halbleiterkörper eine monolithisch integrierte Weißlichtquelle dar.

In Figur 4 ist ein weiteres Ausführungsbeispiel des Halbleiterkörpers 1 in Form eines Dünnfilm-Halbleiterkörpers dargestellt.

Wie im vorherigen Ausführungsbeispiel weist dieser Halbleiterkörper eine Reemissionsschicht 3 und eine aktive Schicht 2 auf und ist weitergehend über eine Kontaktschicht 13 und eine Lotschicht 14 mit einem Träger 12 verbunden. Wie bei dem vorhergehenden Ausführungsbeispiel kann in nicht dargestellter Weise eine Spiegelschicht zwischen dem Halbleiterkörper 1 und dem Träger 12 angeordnet sein.

Im Unterschied zum vorherigen Ausführungsbeispiel ist die laterale Ausdehnung der Reemissionsschicht 3 kleiner als die entsprechende laterale Ausdehnung der aktiven Schicht 2. Auf diese Art und Weise kann die Erzeugung der Strahlung der zweiten Wellenlänge λ₂ auf einen vergleichsweise kleinen Bereich konzentriert werden, so dass gleichsam eine Punktlichtquelle mit einer hohen Strahlungsdichte gebildet wird.

In diesem Fall wird bevorzugt die Strahlung der ersten Wellenlänge λ₂ vollständig in Strahlung der zweiten Wellenlänge umgewandelt oder aber der Austritt der Strahlung der ersten Wellenlänge λ₁ außerhalb der Reemissionsschicht 3 verhindert. Dies kann beispielsweise dadurch erfolgen, dass der Kontakt 15 seitlich von der Reemissionsschicht 3 angeordnet ist, und somit ein Austreten der Strahlung der ersten Wellenlänge λ₁ in diesem Bereich verhindert. Die Strahlung der ersten Wellenlänge λ₁ kann beispielsweise im ultravioletten Spektralbereich liegen und in Strahlung im sichtbaren Spektralbereich, beispielsweise im grünen Spektralbereich, umgewandelt werden.

Alternativ oder ergänzend kann ein Wellenleiter vorgesehen sein, der ebenfalls ein Austreten der Strahlung der ersten Wellenlänge seitlich von der Reemissionsschicht 3 verhindert. Beispielsweise können die Kontaktschichten des Halbleiterkörpers reflektierend ausgeführt sein, so dass zwischen diesen Kontaktschichten ein Wellenleiter gebildet wird.

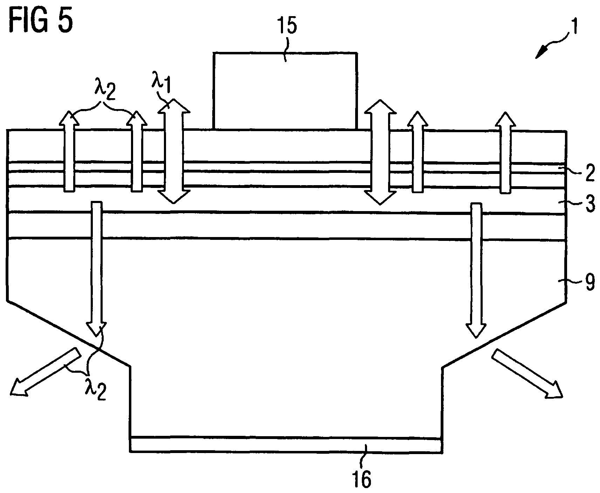

In Figur 5 ist ein viertes Ausführungsbeispiel des strahlungsemittierenden Halbleiterkörpers 1 dargestellt.

Im Unterschied zu den beiden vorherigen Ausführungsbeispielen weist dieser Halbleiterkörper ein für die erzeugte Strahlung der ersten Wellenlänge λ₁ und/oder der zweiten Wellenlänge λ₂ durchlässiges Epitaxiesubstrat 9 auf.

Auf dem Epitaxiesubstrat 9 sind nacheinander die Reemissionsschicht 3 und nachfolgend die aktive Schicht 2 epitaktisch aufgewachsen. Oberseitig ist ein Kontakt 15 in Form eines Bondpads auf den Halbleiterkörper aufgebracht. Vorzugsweise ist das Substrat elektrisch leitfähig und weist weitergehend auf der gegenüberliegenden Seite des Kontakts einen Gegenkontakt 16 zur elektrischen Versorgung des Halbleiterkörpers auf.

Die in der aktiven Schicht 2 erzeugte Strahlung der ersten Wellenlänge λ₁ propagiert teilweise in Richtung der Reemissionsschicht 3 und wird dort zumindest zu Teilen in Strahlung der zweiten Wellenlänge λ₂ umgewandelt. Strahlung der ersten und der zweiten Wellenlänge kann oberseitig von dem Halbleiterkörper abgestrahlt werden. Zusätzlich ist eine Abstrahlung durch das strahlungsdurchlässige Substrat möglich. Hierbei ist es vorteilhaft, das Substrat in der dargestellten Weise mit Ausnehmungen zu versehen, die die Auskoppeleffizienz der erzeugten Strahlung erhöhen.

Eine entsprechende Formgebung des Substrats, bei der eine oder mehrere Seitenwände des Substrats 9 einen schräg verlaufenden Seitenwandteil aufweisen, der in einen senkrecht verlaufenden Seitenwandteil übergeht, ist in dem DE-Patent DE 100 06 738 beschrieben, dessen Offenbarungsgehalt insoweit durch Rückbezug aufgenommen wird.

Diese Patentanmeldung beansprucht die Priorität der deutschen Patentanmeldung 10 2007 046 499.3, deren Offenbarungsgehalt hiermit durch Rückbezug aufgenommen wird.

Die Erfindung ist nicht durch die Beschreibung anhand der Ausführungsbeispiele beschränkt. Vielmehr ist die Erfindung durch die nachfolgenden Patentansprüche definiert.

## Patentansprüche

1. Strahlungsemittierender Halbleiterkörper (1) mit einer aktiven Schicht (2) zur Erzeugung von Strahlung einer ersten Wellenlänge (λ₁) und einer Reemissionsschicht (3), die eine Quantentopfstruktur (4) mit einer Quantenschichtstruktur (5) und einer Barriereschichtstruktur (6) aufweist, wobei die aktive Schicht (2) und die Reemissionsschicht (3) monolithisch in den Halbleiterkörper (1) integriert sind und die Reemissionsschicht zur Erzeugung von inkohärenter Strahlung einer zweiten Wellenlänge (λ₂) mittels Absorption der Strahlung der ersten Wellenlänge in der Barriereschichtstruktur vorgesehen ist.

2. Strahlungsemittierender Halbleiterkörper nach Anspruch 1, wobei
die Strahlung der ersten Wellenlänge inkohärent ist.

3. Strahlungsemittierender Halbleiterkörper nach Anspruch 1 oder 2, wobei
die Quantenschichtstruktur (5) mindestens eine Quantenschicht (7) aufweist und die Barriereschichtstruktur (6) mindestens eine Barriereschicht (8) aufweist.

4. Strahlungsemittierender Halbleiterkörper nach einem der vorhergehenden Ansprüche, wobei
die Strahlung der zweiten Wellenlänge (λ₂) in der Quantenschichtstruktur erzeugt wird.

5. Strahlungsemittierender Halbleiterkörper nach einem der vorhergehenden Ansprüche, wobei
die aktive Schicht (2) und die Reemissionsschicht AlₙGaₘIn₁₋ₙ₋ₘN, mit 0 ≤ n ≤ 1, 0 ≤ m ≤ 1 und n+m ≤ 1 enthalten.

6. Strahlungsemittierender Halbleiterkörper nach einem der vorhergehenden Ansprüche, wobei
die erste Wellenlänge (λ₁) zwischen einschließlich 360 nm und einschließlich 400 nm liegt.

7. Strahlungsemittierender Halbleiterkörper nach einem der vorhergehenden Ansprüche, wobei
die erste Wellenlänge (λ₁) im blauen Spektralbereich liegt und der strahlungsemittierende Halbleiterkörper zur Emission von weißem Licht vorgesehen ist.

8. Strahlungsemittierender Halbleiterkörper nach einem der vorhergehenden Ansprüche, wobei
die Reemissionsschicht (3) die Strahlung der ersten Wellenlänge (λ₁) teilweise in Strahlung der zweiten Wellenlänge (λ₂) derart umwandelt, dass der strahlungsemittierende Halbleiterkörper zur Emission von Strahlung der ersten Wellenlänge und der zweiten Wellenlänge vorgesehen ist.

9. Strahlungsemittierender Halbleiterkörper nach einem der Ansprüche 1 bis 7, wobei
die Reemissionsschicht die Strahlung der ersten Wellenlänge (λ₁) vollständig in Strahlung der zweiten Wellenlänge (λ₂) umwandelt.

10. Strahlungsemittierender Halbleiterkörper nach einem der Ansprüche 1 bis 9, wobei
der Halbleiterkörper ein Dünnfilm-Halbleiterkörper ist.

11. Strahlungsemittierender Halbleiterkörper nach einem der Ansprüche 1 bis 9, wobei
der Halbleiterkörper ein Aufwachssubstrat (9) aufweist, das für die Strahlung der ersten Wellenlänge und/oder die Strahlung der zweiten Wellenlänge durchlässig ist.

12. Strahlungsemittierender Halbleiterkörper nach einem der vorhergehenden Ansprüche, wobei
eine laterale Ausdehnung der Reemissionsschicht (3) kleiner ist als eine entsprechende laterale Ausdehnung der aktiven Schicht (2).

13. Strahlungsemittierender Halbleiterkörper nach einem der vorhergehenden Ansprüche, wobei
ein Kontakt (15) zur elektrischen Versorgung des Halbleiterkörpers (1) derart seitlich von der Reemissionsschicht (3) angeordnet ist, dass ein Austreten der Strahlung der ersten Wellenlänge (λ₁) seitlich von der Reemissionsschicht (3) verhindert wird.

14. Verfahren zur Erzeugung mischfarbiger Strahlung oder zur Umwandlung von Strahlung mittels eines Halbleiterkörpers (1), der eine aktive Schicht (2) und eine Reemissionsschicht (3) enthält, wobei die aktive Schicht (2) und die Reemissionsschicht (3) monolithisch in den Halbleiterkörper (1) integriert sind und die Reemissionsschicht eine Quantentopfstruktur (4) mit einer Quantenschichtstruktur (5) und einer Barriereschichtstruktur (6) aufweist,
mit den Schritten:
- Erzeugen von Strahlung einer ersten Wellenlänge (λ₁) in der aktiven Schicht;
- zumindest teilweises Absorbieren der Strahlung der ersten Wellenlänge in der Barriereschichtstruktur, und
- Erzeugen von inkohärenter Strahlung einer zweiten Wellenlänge (λ₂) in der Quantenschichtstruktur.

15. Verfahren nach Anspruch 14 mit einem Halbleiterkörper nach zumindest einem der Ansprüche 1 bis 13.

## Claims

1. Radiation-emitting semiconductor body (1) having an active layer (2) for generating radiation of a first wavelength (λ₁) and a re-emission layer (3), which comprises a quantum well structure (4) having a quantum layer structure (5) and a barrier layer structure (6), wherein the active layer (2) and the re-emission layer (3) are monolithically integrated into the semiconductor body (1) and the re-emission layer is provided for generating incoherent radiation of a second wavelength (λ₂) by means of absorption of the radiation of the first wavelength in the barrier layer structure.

2. Radiation-emitting semiconductor body according to Claim 1, wherein
the radiation of the first wavelength is incoherent.

3. Radiation-emitting semiconductor body according to Claim 1 or 2, wherein
the quantum layer structure (5) comprises at least one quantum layer (7) and the barrier layer structure (6) comprises at least one barrier layer (8).

4. Radiation-emitting semiconductor body according to any of the preceding claims, wherein
the radiation of the second wavelength (λ₂) is generated in the quantum layer structure.

5. Radiation-emitting semiconductor body according to any of the preceding claims, wherein
the active layer (2) and the re-emission layer contain AlₙGaₘIn₁₋ₙ₋ₘN, where 0 ≤ n ≤ 1, 0 ≤ m ≤ 1 and n+m ≤ 1.

6. Radiation-emitting semiconductor body according to any of the preceding claims, wherein
the first wavelength (λ₁) is between 360 nm and 400 nm inclusive.

7. Radiation-emitting semiconductor body according to any of the preceding claims, wherein
the first wavelength (λ₁) is in the blue spectral range and the radiation-emitting semiconductor body is provided for emitting white light.

8. Radiation-emitting semiconductor body according to any of the preceding claims, wherein
the re-emission layer (3) converts the radiation of the first wavelength (λ₁) partly into radiation of the second wavelength (λ₂) in such a way that the radiation-emitting semiconductor body is provided for emitting radiation of the first wavelength and of the second wavelength.

9. Radiation-emitting semiconductor body according to any of Claims 1 to 7, wherein
the re-emission layer converts the radiation of the first wavelength (λ₁) completely into radiation of the second wavelength (λ₂).

10. Radiation-emitting semiconductor body according to any of Claims 1 to 9, wherein
the semiconductor body is a thin-film semiconductor body.

11. Radiation-emitting semiconductor body according to any of Claims 1 to 9, wherein
the semiconductor body comprises a growth substrate (9), which is transmissive to the radiation of the first wavelength and/or radiation of the second wavelength.

12. Radiation-emitting semiconductor body according to any of the preceding claims, wherein
a lateral extent of the re-emission layer (3) is less than a corresponding lateral extent of the active layer (2).

13. Radiation-emitting semiconductor body according to any of the preceding claims, wherein
a contact (15) for the electrical supply of the semiconductor body (1) is arranged laterally with respect to the re-emission layer (3) in such a way that the radiation of the first wavelength (λ₁) is prevented from emerging laterally with respect to the re-emission layer (3).

14. Method for generating mixed-coloured radiation or for converting radiation by means of a semiconductor body (1) containing an active layer (2) and a re-emission layer (3), wherein the active layer (2) and the re-emission layer (3) are monolithically integrated into the semiconductor body (1) and the re-emission layer comprises a quantum well structure (4) having a quantum layer structure (5) and a barrier layer structure (6),
comprising the following steps:
- generating radiation of a first wavelength (λ₁) in the active layer;
- at least partly absorbing the radiation of the first wavelength in the barrier layer structure, and
- generating incoherent radiation of a second wavelength (λ₂) in the quantum layer structure.

15. Method according to Claim 14 with a semiconductor body according to at least one of Claims 1 to 13.

## Revendications

1. Corps semi-conducteur émetteur de rayonnement (1) comportant une couche active (2) destinée à générer un rayonnement à une première longueur d'onde (λ₁) et une couche de réémission (3) qui comporte une structure de puits quantique (4) ayant une structure de couche quantique (5) et une structure de couche barrière (6), dans lequel la couche active (2) et la couche de réémission (3) sont intégrées de manière monolithique dans le corps semi-conducteur (1) et la couche de réémission est prévue pour générer un rayonnement incohérent à une seconde longueur d'onde (λ₂) par absorption du rayonnement à la première longueur d'onde dans la structure de couche barrière.

2. Corps semi-conducteur émetteur de rayonnement selon la revendication 1,
dans lequel le rayonnement à la première longueur d'onde est incohérent.

3. Corps semi-conducteur émetteur de rayonnement selon la revendication 1 ou 2,
dans lequel la structure de couche quantique (5) comporte au moins une couche quantique (7) et la structure de couche barrière (6) comporte au moins une couche barrière (8).

4. Corps semi-conducteur émetteur de rayonnement selon l'une quelconque des revendications précédentes, dans lequel le rayonnement à la seconde longueur d'onde (λ₂) est généré dans la structure de couche quantique.

5. Corps semi-conducteur émetteur de rayonnement selon l'une quelconque des revendications précédentes, dans lequel la couche active (2) et la couche de réémission contiennent de l'AlₙGaₘIn₁₋ₙ₋ₘN, avec 0 ≤ n ≤ 1, 0 ≤ m ≤ 1 et n+m ≤ 1.

6. Corps semi-conducteur émetteur de rayonnement selon l'une quelconque des revendications précédentes, dans lequel la première longueur d'onde (λ₁) se situe entre 360 nm inclus et 400 nm inclus.

7. Corps semi-conducteur émetteur de rayonnement selon l'une quelconque des revendications précédentes, dans lequel la première longueur d'onde (λ₁) se situe dans le domaine spectral bleu et le corps semi-conducteur émetteur de rayonnement est prévu pour émettre de la lumière blanche.

8. Corps semi-conducteur émetteur de rayonnement selon l'une quelconque des revendications précédentes, dans lequel la couche de réémission (3) convertit partiellement le rayonnement à la première longueur d'onde (λ₁) en un rayonnement à la seconde longueur d'onde (λ₂) de manière à ce que le corps semi-conducteur émetteur de rayonnement soit prévu pour émettre un rayonnement à la première longueur d'onde et à la seconde longueur d'onde.

9. Corps semi-conducteur émetteur de rayonnement selon l'une quelconque des revendications 1 à 7, dans lequel la couche de réémission convertit en totalité le rayonnement à la première longueur d'onde (λ₁) en un rayonnement à la seconde longueur d'onde (λ₂).

10. Corps semi-conducteur émetteur de rayonnement selon l'une quelconque des revendications 1 à 9, dans lequel le corps semi-conducteur est un corps semi-conducteur à couche mince.

11. Corps semi-conducteur émetteur de rayonnement selon l'une quelconque des revendications 1 à 9, dans lequel le corps semi-conducteur comporte un substrat de croissance (9) qui est transparent au rayonnement à la première longueur d'onde et/ou au rayonnement à la seconde longueur d'onde.

12. Corps semi-conducteur émetteur de rayonnement selon l'une quelconque des revendications précédentes, dans lequel une extension latérale de la couche de réémission (3) est inférieure à une extension latérale correspondante de la couche active (2).

13. Corps semi-conducteur émetteur de rayonnement selon l'une quelconque des revendications précédentes, dans lequel un contact (15) destiné à l'alimentation électrique du corps semi-conducteur (1) est disposé sur le côté de la couche de réémission (3) de manière à réduire la sortie du rayonnement à la première longueur d'onde (λ₁) par le côté de la couche de réémission (3).

14. Procédé destiné à générer un rayonnement de couleur mixte ou à convertir un rayonnement au moyen d'un corps semi-conducteur (1) qui contient une couche active (2) et une couche de réémission (3), dans lequel la couche active (2) et la couche de réémission (3) sont intégrées de manière monolithique dans le corps semi-conducteur (1) et la couche de réémission comporte une structure de puits quantique (4) ayant une structure de couche quantique (5) et une structure de couche barrière (6), comportant les étapes consistant à :
- générer un rayonnement à une première longueur d'onde (λ₁) dans la couche active ;
- absorber au moins partiellement le rayonnement à la première longueur d'onde dans la structure de couche barrière, et
- générer un rayonnement incohérent à une seconde longueur d'onde (λ₂) dans la structure de couche quantique.

15. Procédé selon la revendication 14, utilisant un corps semi-conducteur selon au moins l'une des revendications 1 à 13.
